Europäisches Patentamt

(19) European Patent Office

Office européen des brevets

(11) Publication number: **0 263 542**
**B1**

## (12) EUROPEAN PATENT SPECIFICATION

(45) Date of publication of the patent specification:
**13.12.89**

(51) Int. Cl.⁴: **G01N 19/04**

(21) Application number: **87201643.1**

(22) Date of filing: **31.08.87**

(54) Method of pull-testing wire bonds on a micro-miniature solid-state device.

(30) Priority: **05.09.86 GB 8621467**

(43) Date of publication of application:
**13.04.88 Bulletin 88/15**

(45) Publication of the grant of the patent:
**13.12.89 Bulletin 89/50**

(84) Designated Contracting States:
**DE FR GB IT**

(56) References cited:
**US-A- 3 564 911**
**US-A- 3 945 248**
**US-A- 4 453 414**

**IEEE TRANSACTIONS ON COMPONENTS, HYBRIDS AND MANUFACTURING TECHNOLOGY, vol. CHMT-1, no. 3, September 1978, pages 203-210, New York, US; G.G. HARMAN et al.: "The microelectronic wire bond pull test - How to use it, how to abuse it"**
**IEEE TRANSACTIONS ON COMPONENTS, HYBRIDS AND MANUFACTURING TECHNOLOGY, vol. CHMT-6, no. 4, December 1983, pages 503-509, New York, US; R.J. BLAZEK "Development of nondestructive pull-test requirements for gold wires on multilayer thick-film hybrid microcircuits"nfassung**
**Nr. 25 029yLECTROCHEM. 1982, 140(2), 329-46IM.**

(73) Proprietor: **PHILIPS ELECTRONIC AND ASSOCIATED INDUSTRIES LIMITED, Philips House 188 Tottenham Court Road, London W1P 9LE(GB)**

(84) Designated Contracting States: **GB**

(73) Proprietor: **N.V. Philips' Gloeilampenfabrieken, Groenewoudseweg 1, NL-5621 BA Eindhoven(NL)**

(84) Designated Contracting States: **DE FR IT**

(72) Inventor: **Winkle, Roy Victor, Philips Research Laboratories Cross Oak Lane, Redhill RH1 5HA(GB)**

(74) Representative: **Clark, Jane Anne et al, PHILIPS ELECTRONICS Patents and Trade Marks Department Centre Point New Oxford Street, London WC1A 1QJ(GB)**

(56) References cited: (continuation)
**ACTA 1978, 26(1), L13-L14 000**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a method of pull-testing wire bonds on a micro-miniature solid-state device, for example, an integrated circuit or a hybrid circuit. Such bonds consist of an electrically conductive wire which extends between and is bonded at its ends to two bonding pads on the solid-state device, the wire forming a loop between the pads, which may be, for example, two dies or a terminal and a die. The term "wire bond" is to be understood herein to include the entire interconnection between the pads comprising the wire and the bonds at the ends of the wire. These bonds are formed in known manner, for example, by ultrasonic welding.

There is a standard method of pull-testing a wire bond in which a pulling force is applied to the wire loop at a point intermediate the ends of the loop in a direction away from the plane containing the bonds until the wire bond breaks, usually by failure of one of the bonds, or is stressed to a predetermined value. The force is applied by means of a device which moves first to tauten the wire loop and then to apply the pulling force to the loop, and which comprises means such as a force transducer for measuring the applied force and supplying a signal corresponding to the measured force.

This method is discussed in an article by G. G. Harman and C. A. Cannon published in the I.E.E.E. Transactions on Components, Hybrids, and Manufacturing Technology, Vol. CHMT-1, No. 3, September 1978. In the article the authors consider, inter-alia, the geometric variables of the pull test, one of which is the height of the loop. This is influenced by the point between the ends of the loop at which the pulling force is applied; it is also influenced by the length of the loop, that is to say, the length of the wire forming the loop. In the case of gold wire, which has hitherto been commonly used in wire bonds, the length of the loop varies very little from one wire bond to another in a series of identical wire bonds. This is due largely to the malleability of gold and the consequent predictability of the behaviour of the wire as the wire is laid to form the loop between the bonding pads. For reasons of economy there is a growing trend to use copper wire instead of wire of a noble metal, and the springiness of copper wire does tend to produce variations in the length of the wire loop, which will result in variations in the loop height in a series of pull tests.

It is an object of the invention to provide an improved method of pull-testing wire bonds in which variations in loop height due to variations in the length of the loop are taken into account.

According to the invention there is provided a method of pull-testing a wire bond on a micro-miniature solid-state device, in which a pulling force is applied to the wire loop at a point intermediate the ends of the loop in a direction away from the plane containing the bonds at the ends of the loop until the wire bond breaks or is stressed to a predetermined value, the force being applied by means of a device which moves first to tauten the wire loop and then to apply the pulling force to the loop, and which comprises means for measuring the applied force and supplying a signal corresponding to the measured force, characterised in that the movement of the force-applying device is measured by means which supply a signal which corresponds to or from which can be derived the distance through which the force-applying device moves to tauten the wire loop, and therefore the height of the tautened loop, and this signal and the signal corresponding to the measured force are fed to a calculating device in which the measured force is corrected for variation in the height of the tautened loop from a given value.

Preferably, the total distance through which the force-applying device moves first to tauten the wire loop and then to apply a pulling force to the loop until the wire bond is stressed to the predetermined value or breaks is measured and the height of the tautened loop is derived from this measurement by subtracting from it in the calculating device the distance through which the force-applying device moves after tautening the loop until the wire bond is stressed to said predetermined value or breaks.

The invention also provides an apparatus for carrying out the method, the apparatus comprising a device which is movable first to tauten the wire loop and then to apply a pulling force to the loop, and means for measuring the applied force and supplying a signal corresponding to the measured force, characterised by means for measuring the movement of the force-applying device and supplying a signal which corresponds to or from which can be derived the distance through which the force-applying device moves to tauten the wire loop, and a calculating device into which the two signals can be fed and which is programmed to correct said measured force for variation in the distance through which the force-applying device moves to tauten the loop.

A preferred embodiment of the apparatus according to the invention is characterised in that the means for measuring the applied force comprise a force transducer and the means for measuring the movement of the force-applying device comprise a displacement transducer which is arranged to measure, and to supply a signal corresponding to, the total distance through which the force-applying device moves first to tauten the wire loop and then to apply a pulling force to the loop until the wire bond is stressed to the predetermined value or breaks, the signals from the two transducers being fed to the calculating device and the latter being programmed to subtract from said total distance the distance through which the force-applying device moves after tautening the loop until the wire bond is stressed to said predetermined value or breaks.

An embodiment of the apparatus according to the invention in which the force-applying device comprises a member movable by means of a motor and a hook which is engageable with the wire loop in the operation of the apparatus and which is connected to said member via the force transducer for movement with said member first to engage and tauten the loop and then to apply the pulling force thereto, the force transducer comprising an element which is connected to said member for movement therewith and which is deflexible under load for movement relative to said member, and a strain gauge for measuring the deflection of said element and supplying to the calculating device a signal corresponding to the measured deflection, the hook being connected to the deflexible part of the element, is characterised in that the displacement transducer is arranged to measure, and to supply to the calculating device a signal corresponding to, the total distance through which said member moves to tauten the wire loop and apply the pulling force thereto, and the calculating device is programmed to substract from this measurement the deflection of said deflexible element.

An example of the method according to the invention, and an embodiment of the apparatus according to the invention for carrying out the method, will now be described with reference to the accompanying drawings, in which:

Figure 1 is a diagram illustrating the application of a pulling force to the wire loop in a wire-bond pull test, showing the geometric variables of the test, with formulae for the resolution of the forces in the wire,

Figure 2 is a schematic perspective view of an apparatus according to the invention at the beginning of the test in the method according to the invention,

Figure 3 is a view similar to Figure 2 showing the force-applying device at the end of its initial movement to tauten the loop of the wire bond, and

Figure 4 is a view similar to Figures 2 and 3 showing the force-applying device at the point at which one of the bonds at the ends of the wire has parted.

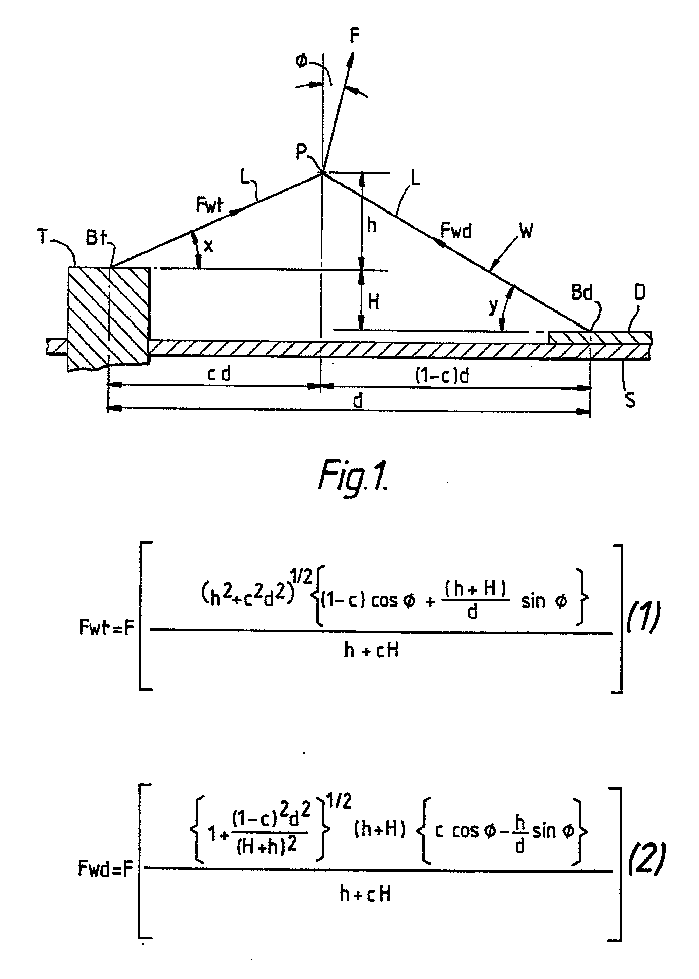

The diagram in Figure 1 shows a wire bond consisting of a wire W connected at its ends by bonds Bt and Bd to bonding pads formed by a terminal T and a die D, respectively, on a substrate S. The wire forms a loop L between the bonding pads. In the pull test a pulling force F is applied to the loop at a point P intermediate the ends of the loop.

In the arrangement shown the bonds Bt and Bd are at different levels separated by a vertical distance H; in the horizontal direction the bonds are separated by a distance d. The vertical distance between the higher bond Bt and the point of application P of the pulling force F is represented by h, and the corresponding horizontal distance by cd. The pulling force F acts in a direction which is inclined to the vertical by an angle Ø, and the position of the point P between the ends of the wire W is such that angles x and y are formed between the wire W and the horizontal at the bonds Bt and Bd respectively. The forces Fwt and Fwd in the wire at the bonds Bt and Bd respectively are given by equations (1) and (2) in Figure 1.

If the bonds are at the same level (H = 0) and the pulling force is applied at the centre of the loop ( c = 1/2) and in a truly vertical direction (Ø = 0), equations (1) and (2) reduce to:

$$F_{wt} = F_{wd} = F/2 \, [1 + (d/2h)^2]^{1/2}$$

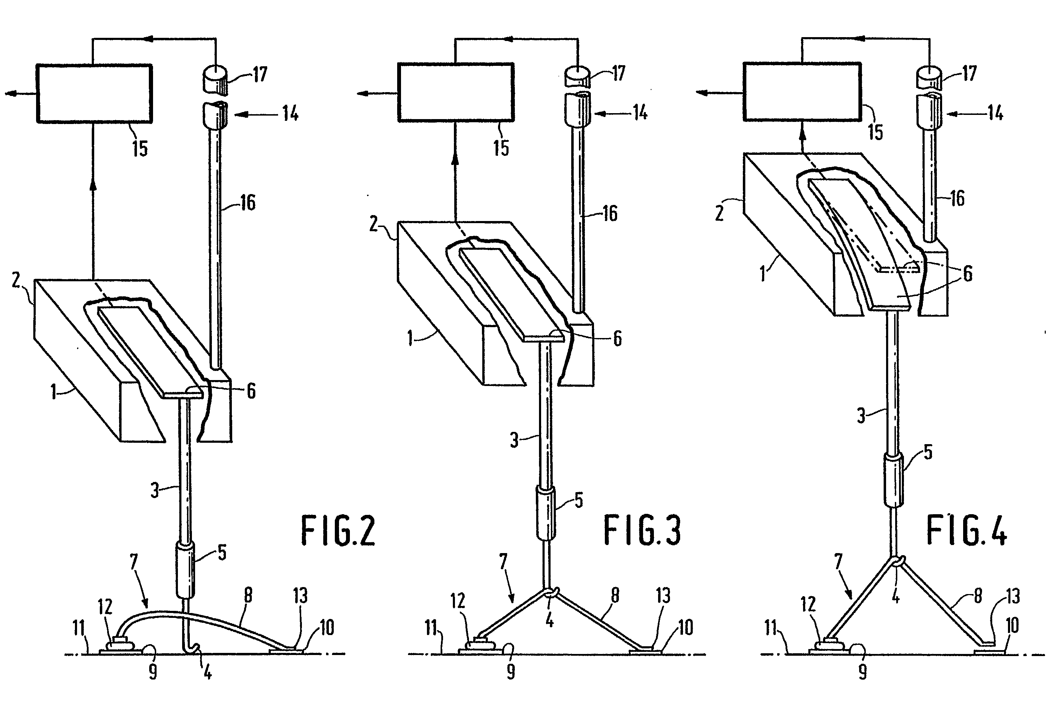

The apparatus shown in Figures 2, 3 and 4 comprises a substantially horizontal loading arm 1 which is pivotally supported at one end 2 for movement in upward and downward directions by means of a motorised drive (not shown). A rod 3 depends vertically from the other, free end of the loading arm, and at its lower end the rod carries a hook 4. The hook is connected to the rod by an adjustable coupling 5 which permits adjustment of the hook relative to the rod in the axial direction of the rod. At its upper end the rod 3 is connected to the free end of a deflexible cantilever beam 6 inside the arm 1. A strain gauge (not shown) is provided on the beam to measure its deflection, the beam and the gauge together forming a known type of force transducer. The apparatus thus far described is known and operates in the following manner. A wire bond 7 is to be tested. The wire bond consists of a wire 8 bonded at its ends to die pads 9 and 10 on a substrate 11 by a ball bond 12 and a wedge bond 13 respectively. With the loading arm 1 in the lowered position shown in Figure 2, the substrate is positioned so that the hook 4 lies directly below the centre of the wire loop of the wire bond 7. The arm 1 is then raised to bring the hook into engagement with the wire loop and then to tauten the loop, as shown in Figure 3. Further upward movement of the loading arm 1 stresses the wire bond, with a corresponding deflection of the beam 6 in the arm, until a predetermined stress value is reached or the wire bond breaks either by parting of the wire or, as shown in Figure 4, by failure of the weaker of the two bonds 12 and 13, which will usually be the wedge bond. Since the load/deflection characteristic of the beam 6 is known, a measurement of the pulling force applied to the wire loop by the arm 1 is obtained from the strain gauge which measures the deflection of the beam.

The force applied to the bonds 12 and 13 will vary with the length of the wire loop, since the length of the loop is a factor determining the height of the loop and, as explained above, the loop height, by which is meant the height of the tautened loop, is an element of the formula which gives the force in the wire at the bonds. As already mentioned, with wire bonds in which copper wire is used the length, and therefore the height, of the wire loop is unpredictable and can vary considerably in a series of pull tests. To provide a correction for this variation, in the embodiment of the invention shown in Figures 2, 3 and 4 the height of the tautened loop is ascertained by measuring the upward movement of the loading arm 1 during each test with a displacement transducer 14 and feeding a signal from this transducer and a signal from the force transducer formed by the beam 6 and the associated strain gauge to a calculating device 15, which in the present embodiment consists of a computer. In this computer the measured force applied to the wire loop by the loading arm 1 is corrected for variation in the loop height from a given value to obtain a corrected measurement of the force actually applied to the bonds 12 and 13. The displacement transducer measures the total distance through which the arm 1 moves from the starting position (Figure 2) to the moment at which the wire bond breaks (Figure 4) and from this measurement is subtracted in the computer 15 the deflection of the beam 6 to give the required measurement of the height of the tautened loop. This height is measured from a selected reference plane which is determined by the position of the hook 4 at the start of each test and which can be varied by adjusting the position to which the loading arm is lowered for the start of the test or by adjusting the hook relative to the rod 3 by means of the coupling 5. The reference plane may be the plane containing the bonds 12 and 13, which in the example shown are at the same level. More conveniently, as shown in Figure 2, the upper surface of the substrate 11 is utilised as the reference plane, since then after each test the loading arm 1 can simply be lowered until the hook 4 abuts the substrate 11 to determine the starting position of the arm for the next test. The computer can be programmed to make allowance in the measurement of the loop height for the cross-sectional diameter of the wire of which the hook 4 is made.

The displacement transducer 14 may be of any convenient known form. In the embodiment shown it consists of a linear variable differential transformer comprising a stationary coil (not shown) arranged within a protective magnetic shield in a fixed, vertically disposed sleeve 17 and comprising a primary winding between two secondary windings which are wired in series opposition. The armature (not shown) of the transformer is carried on a vertically arranged rod 16 which is connected at its lower end to the loading arm 1 at or near the free end thereof for movement up and down with the arm. The armature moves within the hollow core of the coil and, when the primary winding is energised, induces a voltage from the primary to the secondary windings. The position of the armature within the coil determines the level of the voltage at each secondary winding and hence an output voltage that is proportional to the displacement of the armature from null, i.e., the midway position.

Instead of measuring the total upward movement of the loading arm 1 with a displacement transducer and deriving the height of the tautened loop from this measurement by subtracting that part of the movement of the arm in which the wire bond is stressed by the arm, the height of the loop can be obtained by measuring the distance through which the hook 4 moves from the starting position (Figure 2) to tauten the loop (Figure 3) with a non-contacting sensor, for example, an optical transducer, which supplies to the computer 15 a signal corresponding to this movement of the hook.

Although particular reference has been made to the pull-testing of wire bonds made of copper wire, the invention can be used to advantage in the testing of wire bonds made of other wire material.

## Claims

1. A method of pull-testing a wire bond on a microminiature solid-state device, in which a pulling force is applied to the wire loop at a point intermediate the ends of the loop in a direction away from the plane containing the bonds at the ends of the loop until the wire bond breaks or is stressed to a predetermined value, the force being applied by means of a device which moves first to tauten the wire loop and then to apply the pulling force to the loop, and which comprises means for measuring the applied force and supplying a signal corresponding to the measured force, characterised in that the movement of the force-applying device is measured by means which supply a signal which corresponds to or from which can be derived the distance through which the force-applying device moves to tauten the wire loop, and therefore the height of the tautened loop, and this signal and the signal corresponding to the measured force are fed to a calculating device in which the measured force is corrected for variation in the height of the tautened loop from a given value.

2. A method as claimed in Claim 1, characterised in that the total distance through which the force-applying device moves first to tauten the wire loop and then to apply a pulling force to the loop until the wire bond is stressed to the predetermined value or breaks is measured and the height of the tautened loop is derived from this measurement by subtracting from it in the calculating device the distance through which the force-applying device moves after tautening the loop until the wire bond is stressed to said predetermined value or breaks.

3. An apparatus for carrying out the method claimed in Claim 1, comprising a device which is movable first to tauten the wire loop and then to apply a pulling force to the loop, and means for measuring the applied force and supplying a signal corresponding to the measured force, characterised by means for measuring the movement of the force-applying device and supplying a signal which corresponds to or from which can be derived the distance through which the force-applying device moves to tauten the wire loop, and a calculating device into which the two signals can be fed and which is programmed to correct said measured force for variation in the distance through which the force-applying device moves to tauten the loop.

4. An apparatus as claimed in Claim 3 for carrying out the method claimed in Claim 2, characterised in that the means for meausuring the applied force comprise a force transducer and the means for measuring the movement of the force-applying device comprise a displacement transducer which is arranged to measure, and to supply a signal corresponding to, the total distance through which the force-applying device moves first to tauten the wire loop and then to apply a pulling force to the loop until the wire bond is stressed to the predetermined value or breaks, the signals from the two transducers being fed to the calculating device and the latter being programmed to subtract from said total distance the distance through which the force-applying device moves after tautening the loop until the wire bond is stressed to said predetermined value or breaks.

5. An apparatus as claimed in Claim 4, in which the force-applying device comprises a member movable by means of a motor and a hook which is engageable with the wire loop in the operation of the apparatus and which is connected to said member via the force transducer for movement with said member first to engage and tauten the loop and then to apply the pulling force thereto, the force transducer comprising an element which is connected to said member for movement therewith and which is deflexible under load for movement relative to said member, and a strain gauge for measuring the deflection of said element and supplying to the calculating device a signal corresponding to the measured deflection, the hook being connected to the deflexible part of the element, characterised in that the displacement transducer is arranged to measure, and to supply to the calculating device a signal corresponding to, the total distance through which said member moves to tauten the wire loop and apply the pulling force thereto, and the calculating device is programmed to subtract from this measurement the deflection of said deflexible element.

**Patentansprüche**

1. Verfahren zur Zugprüfung einer Drahtverbindung an einem Mikrominiatur-Festkörpergerät, wobei eine Zugkraft auf die Drahtschleife an einen Punkt zwischen den Enden der Schleife in einer Richtung von der Ebene abgehend angelegt wird, die die Bonds an den Enden der Schleife enthält, bis die Drahtverbindung bricht oder bis zu einem vorgegebenen Wert beansprucht wird, wobei die Kraft mittels eines Geräts angelegt wird, das zunächst die Drahtschleife strafft und dann die Zugkraft auf die Schleife ausübt, und dieses Gerät Mittel zum Messen der angelegten Kraft und zum Abgeben eines der gemessenen Kraft entsprechenden Signals enthält, dadurch gekennzeichnet, daß die Verlagerung des Kraftausübungsgeräts mit Mitteln gemessen wird, die ein Signal abgeben, das dem Abstand, über den das Kraftausübungsgerät die Drahtschleife strafft, entspricht oder davon abgeleitet werden kann, also auch die Höhe der gestrafften Schleife ableitbar ist, und dieses Signal sowie das der gemessenen Kraft entsprechende Signal werden einem Rechengerät zugeführt, in dem die gemessene Kraft für eine mögliche Abweichung in der Höhe der gestrafften Schleife von einem gegebenen Wert korrigiert wird.

2. Verfahren nach Anspruch 1, dadurch gekennzeichnet, daß der Gesamtabstand, über den sich das Kraftausübungsgerät zunächst zum Straffen der Drahtschleife und darauf zum Anlegen einer Ziehkraft an die Schleife verlagert, bis die Drahtverbindung bis zum vorgegebenen Wert beansprucht wird oder bricht, gemessen wird und die Höhe der gespannten Schleife von dieser Messung abgeleitet wird, indem davon im Rechengerät der Abstand abgezogen wird, über den das Kraftausübungsgerät sich nach dem Straffen der Schleife verlagert, bis die Drahtverbindung bis zum vorgegebenen Wert beansprucht ist oder bricht.

3. Apparat zur Durchführung des Verfahrens nach Anspruch 1, mit einem Gerät, das zunächst zum Straffen der Drahtschleife und anschließend zum Anlegen einer Zugkraft an die Schleife verlagerbar ist, und Mittel zum Messen der angelegten Kraft und zum Abgeben eines der gemessenen Kraft entsprechenden Signals enthält, dadurch gekennzeichnet, daß Mittel zum Messen der Bewegung des Kraftausübungsgeräts und zum Abgeben eines Signals vorgesehen sind, daß dem Abstand entspricht, über den das Kraftausübungsgerät sich zum Straffen der Drahtschleife verlagert, oder davon ableitbar ist, und ein Berechnungsgerät vorgesehen ist, dem die beiden Signale zuführbar sind und das zum Korrigieren der gemessenen Kraft für Abweichungen im Abstand programmiert ist, über den das Kraftausübungsgerät sich zum Straffen der Schleife verlagert.

4. Apparat nach Anspruch 3 zur Durchführung des Verfahrens nach Anspruch 2, dadurch gekennzeichnet, daß die Mittel zum Messen der angelegten Kraft einen Kraftwandler enthalten, und die Mittel zum Messen der Verlagerung des Kraftausübungsgeräts einen Verschiebungswandler enthalten, die zum Messen und zum Abgeben eines Signals vorgesehen ist, das dem Gesamtabstand entspricht, über den das Kraftausübungsgerät sich zunächst zum Straffen der Drahtschleife und anschließend zum Abgeben einer Zugkraft an die Schleife verlagert, bis die Drahtverbindung bis zum vorgegebenen Wert beansprucht ist oder bricht, wobei die Signale aus den beiden Wandlern an das Berechnungsgerät gelangen und dieses dahin programmiert ist, daß vom Gesamtabstand der Abstand abgezogen wird, über den das Kraftausübungsgerät sich nach dem Straffen der Schleife verlagert, bis die Drahtverbindung bis zum vorgegebenen Wert beansprucht ist oder bricht.

5. Apparat nach Anspruch 4, in dem das Kraftausübungsgerät ein Element enthält, das mit Hilfe eines Motors und eines Hakens bewegbar ist, der im Betrieb des Apparats an die Drahtschleife gehängt werden kann und über den Kraftwandler zur Verlagerung dieses Elements zunächst zum Anhaken und Straffen der Schleife und anschließend zum Abgeben der Zugkraft darauf mit dem Element verbunden wird, wobei der Kraftwandler ein Element, das mit dem Zugelement zum gleichzeitigen Verlagern verbunden ist und unter Belastung für eine Verlagerung in bezug auf das Zugelement unflexibel ist, und einen Dehnungsmeßstreifen zum Messen der Ablenkung des Zugelements und zum Abgeben eines Signals entsprechend der gemessenen Ablenkung zum Berechnungsgerät enthält, wobei der Haken an den unflexiblen Teil des Elements angehängt wird, dadurch gekennzeichnet, daß der Verschiebungswandler zum Messen und zum Abgeben eines Signals entsprechend dem Gesamtabstand zum Berechnungsgerät angeordnet ist, über welchen Gesamtabstand sich das Zugelement zum Straffen der Drahtschleife und zum Anlegen der Zugkraft verlagert, und das Berechnungsgerät daraufhin programmiert ist, daß die Ablenkung des unflexiblen Elements von der Messung abgezogen wird.

**Revendications**

1. Procédé d'essai en tirage d'une connexion de fil sur un composant semi-conducteur microminiature, selon lequel une force de tirage est appliquée à la boucle de fil en un point situé entre ses extrémités dans un sens s'écartant du plan contenant les jonctions aux extrémités de la boucle jusqu'à ce que la connexion de fil se rompe ou soit mise sous contrainte jusqu'à une valeur prédéterminée, la force étant appliquée au moyen d'un dispositif qui se déplace tout d'abord pour tendre la boucle de fil, puis pour y appliquer la force de tirage et qui comprend des moyens pour mesurer la force appliquée et pour fournir un signal correspondant à la force mesurée, caractérisé en ce que le déplacement du dispositif applicateur de force est mesuré par des moyens fournissant un signal qui correspond à ou duquel peut être déduite la distance de laquelle le dispositif applicateur de force se déplace pour tendre la boucle de fil et, par conséquent, la hauteur de la boucle tendue, et ce signal, ainsi que le signal correspondant à la force mesurée, sont appliqués à un dispositif calculateur dans lequel la force mesurée est corrigée pour tenir compte de la variation de la hauteur de la boucle tendue par rapport à une valeur donnée.

2. Procédé suivant la revendication 1, caractérisé en ce que la distance totale de laquelle le dispositif applicateur de force se déplace tout d'abord pour tendre la boucle de fil, puis pour appliquer une force de tirage à cette boucle jusqu'à ce que la connexion de fil soit mise sous une contrainte de valeur prédéterminée ou se rompe, est mesurée et la hauteur de la boucle tendue est déduite de cette mesure en en soustrayant, dans le dispositif calculateur, la distance de laquelle le dispositif applicateur de force se déplace, après avoir tendu la boucle, jusqu'à ce que la connexion de fil soit mise sous contrainte jusqu'à la valeur prédéterminée ou se rompe.

3. Appareil pour effectuer le procédé suivant la revendication 1, comprenant un dispositif qui peut être déplacé tout d'abord pour tendre la boucle de fil, puis pour appliquer une force de tirage à cette boucle, et des moyens pour mesurer la force appliquée et fournir un signal correspondant à la force mesurée, caractérisé par des moyens pour mesurer le déplacement du dispositif applicateur de force et fournir un signal qui correspond à ou duquel peut être déduite la distance de laquelle le dispositif applicateur de force se déplace pour tendre la boucle de fil, et un dispositif calculateur dans lequel les deux signaux peuvent être introduits et qui est programmé pour corriger la force mesurée pour tenir compte de la variation de la distance de laquelle le dispositif applicateur de force se déplace pour tendre la boucle.

4. Appareil suivant la revendication 3 pour exécuter le procédé suivant la revendication 2, caractérisé en ce que les moyens destinés à mesurer la force appliquée comprennent un transducteur de force et les moyens destinés à mesurer le déplacement du dispositif applicateur de force comprennent un transducteur de déplacement qui est conçu pour mesurer et pour fournir un signal correspondant à la distance totale de laquelle le dispositif applicateur de force se déplace tout d'abord pour tendre la boucle de fil, puis pour appliquer une force de tirage à cette boucle jusqu'à ce que la connexion de fil soit soumise à une contrainte de la valeur prédéterminée ou se rompe, les signaux des deux transducteurs étant appliqués au dispositif calculateur et ce dernier étant programmé pour soustraire de la distance totale, la distance de laquelle le dispositif applicateur de force se déplace après avoir tendu la boucle jusqu'à ce que la connexion de fil soit soumise à une contrainte de la valeur prédéterminée ou se rompe.

5. Appareil suivant la revendication 4, dans lequel le dispositif applicateur de force comprend un organe mobile sous l'intervention d'un moteur et un crochet qui peut être engagé avec la boucle de fil pendant le fonctionnement de l'appareil et qui est relié à l'organe par l'intermédiaire du transducteur de force de manière à se déplacer avec l'organe tout d'abord pour engager et tendre la boucle, puis pour appliquer la force de tirage à cette boucle, le transducteur de force comprenant un élément qui est relié à l'organe de manière à se déplacer avec lui et qui peut fléchir sous l'effet de la charge de manière à se déplacer par rapport à l'organe, et une jauge de contrainte pour mesurer la flexion de l'élément et fournir au dispositif calculateur un signal correspondant à la flexion mesurée, le crochet étant relié à la partie flexible de l'élément, caractérisé en ce que le transducteur de déplacement est conçu pour mesurer la distance totale de laquelle l'organe se déplace pour tendre la boucle de fil et pour y appliquer la force de tirage et pour fournir au dispositif calculateur un signal qui y correspond, et le dispositif calculateur est programmé pour soustraire, de cette mesure, la flexion de l'élément flexible.

*Fig.1.*

$$Fwt=F\left[\cfrac{\left(h^2+c^2d^2\right)^{1/2}\left\{(1-c)\cos\phi+\cfrac{(h+H)}{d}\sin\phi\right\}}{h+cH}\right]\quad(1)$$

$$Fwd=F\left[\cfrac{\left\{1+\cfrac{(1-c)^2d^2}{(H+h)^2}\right\}^{1/2}(h+H)\left\{c\cos\phi-\cfrac{h}{d}\sin\phi\right\}}{h+cH}\right]\quad(2)$$

FIG.2

FIG.3

FIG.4